# EUROPEAN PATENT APPLICATION

(11) **EP 4 793 225 A1**
(43) Date of publication of application: **19.08.2026**
(21) Application number: 25158206.0
(22) Date of filing: 17.02.2025
(51) Int. Cl.: B81B 7/02, B81C 1/00

(54) **MICROELECTROMECHANICAL SYSTEM**

(71) Applicant: Murata Manufacturing Co., Ltd., Nagaokakyo-shi, Kyoto 617-8555 (JP)
(72) Inventor: KILPINEN, Petteri, 02620 Espoo (FI)
(74) Representative: Boco IP Oy Ab

(57) **Abstract**

The disclosure relates to microelectromechanical system comprising an ASIC layer, a handle layer, a device layer and a cap layer vertically attached to each other in a given order. The device layer is electrically connected to the ASIC layer through the handle layer.

## Description

### FIELD OF THE DISCLOSURE

The present disclosure relates to a microelectromechanical system. The disclosure further relates to a fabrication method of the microelectromechanical system.

### BACKGROUND OF THE DISCLOSURE

Microelectromechanical (MEMS) devices, such as for measuring acceleration, rotation rate, magnetic field, pressure and/or combination of those, commonly comprise a MEMS chip, where the transducer structure is located, and an ASIC chip, designed to evaluate the measured signal from the MEMS chip. Traditionally, the MEMS and ASIC chips are separate from each other, the signals from the active MEMS chip are transmitted to the ASIC chip, from where they are forwarded to the outside of the MEMS device using wire bonding.

An alternative solution is stacking the ASIC chip vertically on the MEMS chip, as disclosed in publication US20160152466A1. However, the arrangement of US20160152466A1 requires modifying the ASIC with through plugs in order to route the ASIC signal to the outside. This required modification complicates the fabrication process of the MEMS device. Therefore, a solution which can use standard ASIC wafer processing for simplification of the overall fabrication process is desired.

### BRIEF DESCRIPTION OF THE DISCLOSURE

An object of the present disclosure is to provide a MEMS system so as to solve the above problem.

The object of the disclosure is achieved by a MEMS system which is characterized by what is stated in the independent claims. Some embodiments of the disclosure are disclosed in the dependent claims.

The disclosure is based on the idea of a MEMS system comprising an ASIC layer, a handle layer, a device layer and a cap layer stacked to each other, wherein the first side of the handle layer is attached to the ASIC layer, and the device layer is electrically connected to the ASIC layer through the handle layer.

### BRIEF DESCRIPTION OF THE DRAWINGS

In the following the disclosure will be described in greater detail by means of preferred embodiments with reference to the accompanying drawings, in which:
Figure 1a illustrates a MEMS system with one isolated enclosure;
Figure 1b illustrates a MEMS system with two isolated enclosures;
Figure 2a illustrates an example of the MEMS system with one movable structure;
Figure 2b illustrates an example of the MEMS system with two movable structures;
Figure 2c illustrates an example of the MEMS system with electrically connected ASIC layer, handle layer and device layer;
Figure 3a illustrates a first example of outside electrical connection of an ASIC layer;
Figure 3b illustrates a second example of outside electrical connection of the ASIC layer;
Figure 4a illustrates a fabrication process of the MEMS system;
Figure 4b illustrates an exemplary fabrication process of the electrical connection between the handle layer and the device layer.

### DETAILED DESCRIPTION OF THE DISCLOSURE

The disclosure relates to a microelectromechanical system, comprising an ASIC layer, wherein the ASIC layer comprises a control circuit, a handle layer, wherein the handle layer comprises a first side and a second side, a device layer, wherein the device layer comprises a first side and a second side, wherein the first side of the device layer is attached to the second side of the handle layer, and a cap layer attached to the second side of the device layer, wherein and the device layer is electrically connected to the ASIC layer through the handle layer, characterized in that the first side of the handle layer is attached to the ASIC layer.

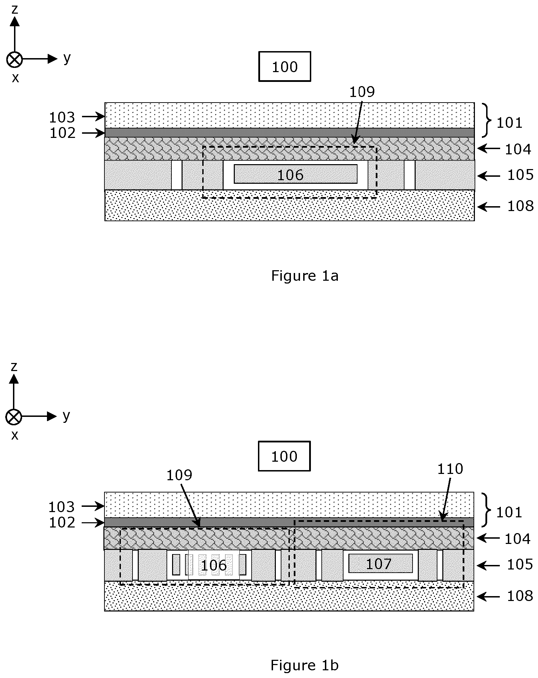

A microelectromechanical (MEMS) system 100 of this disclosure is illustrated in Figure 1. It comprises an ASIC layer 101. The ASIC layer 101 comprises a control circuit 102. The ASIC layer may comprise a first layer and a second layer attached one above the other. The first layer may be an ASIC substrate 103. The second layer may be the control circuit 102. The ASIC layer may comprise a first side and a second side. The first side may correspond to the ASIC substrate 103. The second side may correspond to the control circuit 102.

The microelectromechanical system, wherein the ASIC layer is bonded to the handle layer.

The MEMS system 100 further comprises a handle layer 104. The handle layer 104 may be called a substrate. The handle layer 104 comprises a first side and a second side opposite to each other. The control circuit 102 of the ASIC layer 101 may be attached to the first side of the handle layer 104. Specifically, the second side of the ASIC layer 101 may be attached to the first side of the handle layer 104. In other words, the handle layer 104 may be directly attached to the ASIC layer 101 and there may be no oxide layer in between. The ASIC layer 101 may be bonded to the first side of the handle layer 104 by means of metal bonding. Other attachment options are possible as well.

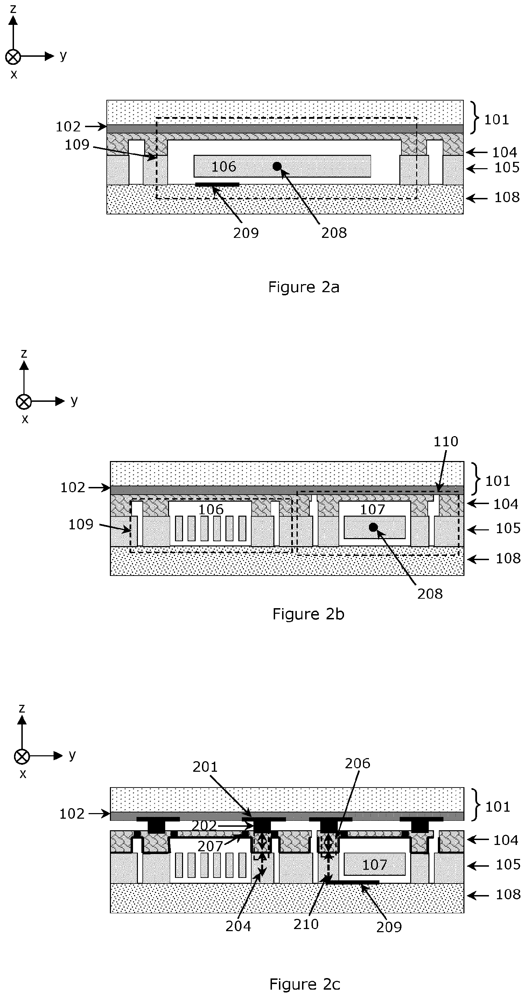

The handle layer 104 may be non-recessed, as illustrated in Figure 1. Alternatively, the handle layer may be recessed, as illustrated in Figures 2a-2c. These options are discussed in more detail later in this disclosure.

The material of the handle layer may be silicon. The thickness of the handle layer in the z-direction may be 50-800 um. The thickness of the handle layer in the z-direction may be more than 50 um, more than 150 um, more than 300 um, more than 600 um. The thickness of the handle layer in the z-direction may be less than 800 um, less than 500 um, less than 250 um, less than 100 um. The thickness of the handle layer in the z-direction may be 1-40 times greater than the thickness in the z-direction of the device layer. The thickness of the handle layer in the z-direction may be equal to or 2 times, 5 times, 10 times, 20 times or 40 times greater than the thickness in the z-direction of the device layer.

The MEMS system 100 further comprises a device layer 105. The device layer comprises a first side and a second side. The second side of the handle layer 104 is attached to the first side of the device layer 105. Specifically, the second side of the handle layer 104 may be directly attached to the first side 1051 of the device layer 105. In other words, there may be no oxide layer in between the second side of the handle layer 104 and the first side of the device layer 105. Alternatively, a first oxide layer may be between the second side of the handle layer 104 and the first side of the device layer 105 (illustrated in Figure 2c). Alternatively, the device layer and the handle layer may be formed from a single silicon-on-insulator (SOI) structure, where the handle layer and device layer are formed on the opposite sides of a silicon dioxide (insulator) layer. In general, the handle layer may be a support layer which supports the device layer during the manufacturing process.

The material of the device layer may be silicon. The thickness of device layer in the z-direction may be 20-100 um. The thickness of device layer in the z-direction may be more than 20 um, more than 40 um, more than 60 um, more than 80 um. The thickness of device layer in the z-direction may be less than 100 um, less than 75 um, less than 50 um, less than 30 um.

The device layer 105 may define a device plane. The device plane may also be called a horizontal plane or xy-plane. Words such as "horizontal", "vertical", "bottom" and "top", "above" and "below" etc. do not in this disclosure refer to the orientation of the device with regard to the direction of earth's gravitational field either when the device is manufactured or when it is in use. Instead, the word "horizontal" simply defines a plane and "vertical" defines a direction which is perpendicular to that plane. The other terms then refer to relative positions in this "vertical" direction.

In this disclosure, the first side of each described layer is the one with the greater z-coordinate than the second side. In other words, each described layer is oriented such that the first side corresponds to the surface of the layer with the greater z-coordinate, while the second side corresponds to the surface of the layer with the lower z-coordinate.

The device layer 105 may comprise a first movable structure 106, as illustrated in Figures 1a and 2a. The device layer 105 may comprise moving parts, such as the first movable structure 106. Further, the device layer 105 may comprise static parts (not marked). The static parts of the device layer may define the device plane. Alternatively, the moving parts in non-actuated state may define the device plane.

The first movable structure 106 may be configured to move out of the device plane. Specifically, the first movable structure 106 may be configured to rotate around a first rotation axis. The first rotation axis may lie in the device plane. The first rotation axis may be along the x-direction and pass through the point 208. The first movable structure 106 may be configured to move linearly along the z-direction out of the device plane. The first movable structure 106 may be configured to move in the device plane. In other words, the first movable structure 106 may be configured to move along the x-direction and/or the y-direction.

Alternatively, the device layer 105 may comprise a first movable structure 106 and a second movable structure 107, as illustrated in Figures 1b and 2b. The first movable structure 106 and the second movable structure 107 may be configured to move independently from each other. The device layer 105 may comprise moving parts, such as the first movable structure 106 and the second movable structure 107. Further, the device layer 105 may comprise static parts (not marked). The static parts of the device layer may define the device plane. Alternatively, the moving parts in non-actuates state may define the device plane.

The first movable structure 106 and the second movable structure 107 may be configured to move out of the device plane. Specifically, the first movable structure 106 and the second movable structure 107 may be configured to rotate around a first rotation axis. The first rotation axis may lie in the device plane. The first rotation axis may be along the x-direction and pass through point 208, as illustrated in Figures 2a and 2b. Alternatively, the first movable structure 106 and the second movable structure 107 may be configured to move linearly along the z-direction.

The first movable structure 106 and the second movable structure 107 may be configured to move in the device plane. In other words, the movable structures may move along the x-direction and/or the y-direction. The device layer 105 may be recessed in the positive z-direction at the second side only, as illustrated in Figures 2a-2c. In this case, the handle layer 104 has to be recessed in the positive z-direction at the second side in order to allow the movable parts of the device layer 105 to move along the z-direction. Alternatively, some parts of the device layer 105 may be recessed in the negative z-direction at the first side, as illustrated in Figures 1a and 1b. In this case, the handle layer 104 may be non-recessed in the z-direction, as illustrated in Figures 1a-1b, or the handle layer 104 may be recessed in the positive z-direction at the second side (not illustrated in Figures 1a-1b). The recessing of the device layer and/or the handle layer allows forming a gap between the movable structure(s) in the device layer and the handle layer and/or cap layer. The gap may be needed for movement of the movable structure(s).

The microelectromechanical system, wherein the cap layer is bonded to the device layer.

The MEMS system further comprises a cap layer 108. The cap layer 108 may be attached to the second side of the device layer 105. The cap layer 108 may comprise a first side, which may be attached to the device layer 105. The cap layer 108 may be bonded to the device layer 105 by means of anodic bonding. Other attachment options are possible as well. The cap layer 108 may comprise a second side, which is opposite to the first side.

The ASIC layer 101, the handle layer 104, the device layer 105 and the cap layer 108 may be attached to one another in the vertical direction is the described order.

The ASIC, handle and device layers of the MEMS system may be electrically connected, as illustrated in Figure 2c. The ASIC layer 101 may comprise ASIC conductive pads 201 at the second side. Specifically, the control circuit 102 may comprise ASIC conductive pads 201. The handle layer 104 may comprise handle conductive pads 202 at the first side.

The microelectromechanical system, wherein the handle layer and device layer are electrically connected by means of polysilicon plugs.

The device layer 105 is electrically connected to the ASIC layer 101 through the handle layer 104. The device layer 105 and the handle layer 104 may be electrically connected by means of, for example, conductive elements, such as device conductive elements 204, as illustrated in Figure 2c. The device conductive elements 204 may extend through the device layer 105. The device conductive elements 204 may extend all the way through the device layer 105 from the first side to the second side. The device conductive elements 204 may be in electrical contact with the handle layer 104. The device conductive elements 204 may be, for example, polysilicon plugs. Other types of device conductive elements 204 is possible.

The ASIC layer 101 may be electrically connected to the first side of the handle layer 104. The handle conductive pads 202 on the first side of the handle layer 104 may be used to electrically connect the handle layer 104 to the ASIC layer 101. The ASIC conductive pads 201at the second side of the ASIC layer 101 may be aligned with and attached to the handle conductive pads 202 at the first side of the handle layer 104.

The device layer 105 may be electrically connected to the ASIC layer 101 through the handle layer 104 by means of MEMS vias 206, illustrated in Figure 2c. The MEMS vias may also be called measurement vias. The MEMS vias 206 may extend from the first side of the handle wafer to the second side of the handle wafer. The MEMS vias 206 may electrically connect the handle conductive pads 202 to the device conductive element 204. The MEMS vias 206 may be used to deliver signals from the device layer 105 structures, such as detected position of the movable structures, to the ASIC layer 101 for processing.

The most efficient design of the MEMS system 100 is when the MEMS vias 206 are positioned closer to the center of the MEMS system 100 in the device plane. This arrangement is especially beneficial when the movable structures in the device layer 105 are positioned closer to the center of the MEMS system 100 in the device plane.

At the surface of the first side of the handle layer 104, the MEMS vias 206 may be insulated by means of, for example, oxide, such as 207.

The vias discussed above may be through silicon vias (TSVs).

In the MEMS system of this disclosure, at least one isolated enclosure may be formed between the ASIC layer 101 and the cap layer 108. The term "isolated" may mean that the enclosure is hermetically sealed from the external environment and from another enclosure, if more than one is present.

As illustrated in Figures 1a and 2a, a first isolated enclosure 109 with part of the device layer 105 inside may be formed between the cap layer 108 and the handle layer 104. In this example, only one isolated enclosure may be formed. The first movable structure 106 may be in the first isolated enclosure 109. Any structural option or example discussed later with regard to the MEMS system with two enclosures (such as in Figures 1b, 2b-2c, 3a-3b and 4) can be implemented with the MEMS structure comprising only one enclosure (such as in Figures 1a and 2a).

The microelectromechanical system, wherein a first isolated enclosure is formed between the cap layer and the handle layer.

The microelectromechanical system of any of the preceding claims, wherein a second isolated enclosure is formed between the cap layer and the ASIC layer. As illustrated in Figures 1b and 2b, the handle layer 104 and the cap layer 108 may form a first isolated enclosure 109 with the device layer 105 inside. The ASIC layer 101 and the cap layer 108 may form a second isolated enclosure 110 with the device layer 105 and part of the handle layer 104 inside. In other words, one part of the device layer 105 may be in the first isolated enclosure 109, and another part of the device layer 105 may be in the second isolated enclosure 110.

The microelectromechanical system, wherein the pressure in the first enclosure is different from the pressure in the second enclosure.

The microelectromechanical system, wherein the device layer comprises a first movable structure, and the first movable structure is suspended in the first isolated enclosure.

The microelectromechanical system, wherein the device layer comprises a second movable structure, and wherein the second movable structure is suspended in the second isolated enclosure.

When two isolated enclosures are formed, pressure in the first isolated enclosure 109 is different from pressure in the second isolated enclosure 110. The pressure in the first isolated enclosure 109 may be lower than in the second isolated enclosure 110. Specifically, the pressure in the first isolated enclosure 109 may be a vacuum. The fabrication process of the MEMS system (introduced below) allows providing different pressures in the first isolated enclosure and in the second isolated enclosure, which are crucial for the movable structures inside the isolated enclosures to operate correctly. In the fabrication process, pressure setting is reliable and efficient as it does not require any additional structural modifications in the MEMS system. The pressure is set when bonding the ASIC layer to the interposer layer (with, for example, metal bonding), and the cap layer to the MEMS layer (with, for example, anodic bonding).

The second movable structure 107 may be in the second isolated enclosure 110.

The microelectromechanical system, wherein the cap layer comprises a first measurement electrode in the second isolated enclosure, and wherein the first measurement electrode is electrically connected to the ASIC layer by means of a measurement via, wherein the measurement via is arranged through the device layer and the handle layer.

When only the first isolated enclosure 109 is present, such as in Figures 1a and 1b, a first measurement electrode 209 may be in the first isolated enclosure 109. Alternatively, when two isolated enclosures are present, the first measurement electrode 209 may be in the first isolated enclosure 109 or in the second isolated enclosure 110, as illustrated in Figure 2c. Specifically, the first measurement electrode 209 may be at the first side of the cap layer 108. The first measurement electrode 209 may be configured to measure out of the device plane displacement of the first or the second movable structure 106-107. Specifically, the out of device plane displacement of the first or the second movable structure 106-107 may be measured using capacitance change in the first measurement electrode 209.

The first measurement electrode 209 may be electrically connected to the ASIC layer 101. This is illustrated in Figure 2c, where one of the device conductive elements 210 is electrically connected to the first measurement electrode 209 and to the MEMS via 206. The device conductive element, such as 210, and the MEMS via 206 together may be called a measurement via when they are configured to electrically connect the first measurement electrode with the ASIC layer. The measurement via may be configured to deliver signal detected from the movable structure (such as 107 in the example of Figure 2c) to the ASIC layer through the device layer 105 and handle layer 104.

The first movable structure may be a gyroscope.

In the MEMS system with only the first isolated enclosure 109, such as in Figures 1a and 1b, the first movable structure 106 may be a gyroscope. In this case, the MEMS system may be a gyroscope. Alternatively, in the MEMS structure with two isolated enclosures, such as in Figures 1b and 2b, the first movable structure 106 or the second movable structure 107 may be a gyroscope.

A gyroscope is a device used to detect and measure changes in angular velocity and orientation of an object. Traditional MEMS gyroscopes contain a mobile proof mass, such as 107 in Figure 1, which usually comprises a part of a silicon wafer. The mobile proof mass is suspended from a fixed element, which is usually a fixed part of the same wafer. The proof mass is connected to force transducers which drive the proof mass into oscillating motion. When the gyroscope is subjected to angular rotation, the Coriolis effect causes the oscillation of the mobile proof mass to be modulated. This modulation of oscillation is directly proportional to the angular rate of the gyroscope and the magnitude of the angular rotation rate can be determined.

The second movable structure may be an accelerometer.

In the MEMS system with only the first isolated enclosure 109, such as in Figures 1a and 1b, the first movable structure 106 may be an accelerometer. In this case, the MEMS system may be an accelerometer. Alternatively, in the MEMS structure with two isolated enclosures, such as in Figures 1b and 2b, the first movable structure 106 or the second movable structure 107 may be an accelerometer.

An accelerometer is a device used to detect and measure the magnitude of the acceleration of an object. In a traditional MEMS accelerometer, a mass element, such as 108 in Figure 1, is suspended from a fixed structure with flexible suspension springs. When an external force acts on the accelerometer so that it accelerates, the mass element is displaced from its rest position. By measuring the magnitude of this displacement with a force transducer, the magnitude of the acceleration can be determined. An accelerometer should ideally not give any output signal when it is experiencing steady-state motion.

The MEMS system with only the first isolated enclosure 109, such as in Figures 1a and 1b, may be both a gyroscope and an accelerometer.

The pressure in the isolated enclosure, where the gyroscope is, may be lower than in another isolated enclosure, where the accelerometer is. Specifically, the pressure in the isolated enclosure with the gyroscope may be a vacuum.

The MEMS device of this disclosure may alternatively function as a pressure sensor. The second isolated enclosure may be sealed with the fixed pressure inside. The first isolated enclosure may comprise an opening in the cap layer, which may be sealed and resealed to allow outside pressure to enter the first isolated enclosure. The pressure in the first isolated enclosure may then be identified by comparing it to the pressure in the second isolated enclosure. Similar structure of the MEMS device may be used for a humidity sensor.

The microelectromechanical system, wherein the ASIC layer is electrically connected to the cap layer by means of ASIC vias in the handle layer and the device layer, and signals from the ASIC layer are routed outside of the MEMS system from the cap layer.

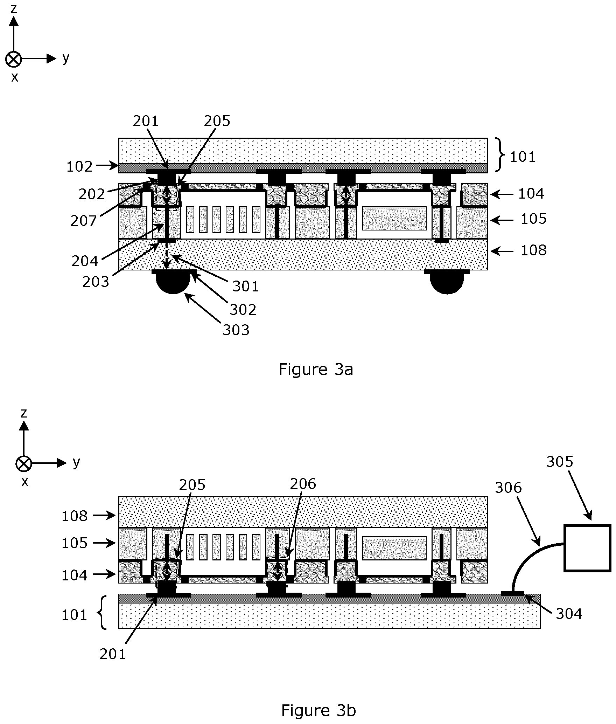

Figure 3a illustrates an example of how the signals from the MEMS system 100 may be routed to the outside. In this example, the ASIC layer 101 may be electrically connected to the cap layer 108 by means of ASIC vias such as, for example, ASIC TSVs, which are schematically illustrated as 205. The ASIC vias 205 may be used to deliver signals from the ASIC layer 101 to the cap layer 108 and to the outside of the MEMS system 100. The ASIC vias 205 may be arranged through the handle layer 104. At the surface of the first side of the handle layer 104, the ASIC vias 205 may be insulated by means of, for example, oxide, such as 207. The handle layer 104 and the device layer 105 may be connected via device conductive elements 204, as was discussed earlier in this disclosure.

The first side of the cap layer 108 may be electrically connected to the second side of the device layer 105. The cap conductive pads 203 at the first side of the cap layer 108 may be aligned with and attached to the device conductive elements 204, as illustrated in Figure 3a. The cap layer may comprise cap conductive elements 301, such as cap vias. The cap conductive elements 301 may electrically connect the cap conductive pads 203.

The cap conductive elements 301301 may be terminated at output electrodes 302 in the second side of the cap layer 108. The output electrodes 302 may be electrically connected to the outside of the MEMS system 100. For example, the cap layer 108 may comprise electrically conductive solder balls 303 at the second side which may be connected to the external printed circuit board (PCB, not illustrated).

The most efficient design of the MEMS system 100 is when the ASIC vias 205 are positioned closer to the edges of the MEMS system 100 in the device plane, while the MEMS vias 206 are positioned closer to the center of the MEMS system 100 in the device plane.

The benefit of this arrangement is that lateral space in the design of the MEMS system is reduced since all electrical connections are arranged vertically.

The microelectromechanical system, wherein signals from the ASIC layer outside of the MEMS system are configured to be routed directly from the ASIC layer.

The microelectromechanical system, wherein the signals from the ASIC layer to outside of the MEMS system are configured to be routed through a wire connected to the ASIC layer.

Alternatively, the signals may be directly routed from the ASIC layer 101 to the outside of the MEMS system 11, as illustrated in Figure 3b. Specifically, the ASIC layer 101 may comprise an output electrode, such as 304, at the second side. The output electrode may be electrically connected to the outside PCB (schematically illustrated as 305) by means of, for example, wire bonding 306. In this arrangement, the cap layer 108 may be passive and comprise no electrically conductive elements. Alternatively, the cap layer 108 may comprise electrically conductive elements, which are electrically connected to the device layer 105, the handle layer 104 and/or the ASIC layer 101, but not directly electrically connected to the outside of the MEMS system 100.

The benefit of this arrangement is that the fabrication process of the MEMS system is simplified since less vias for internal signal routing are required.

### Fabrication method

A method of fabricating a microelectromechanical system of any of the preceding claims, comprising steps of providing a handle layer with a device layer on its second side, wherein the handle layer is electrically connected to the device layer, attaching a cap layer to the device layer, attaching an ASIC layer to a first side of the handle layer, so that the device layer is electrically connected to the ASIC layer through the handle layer.

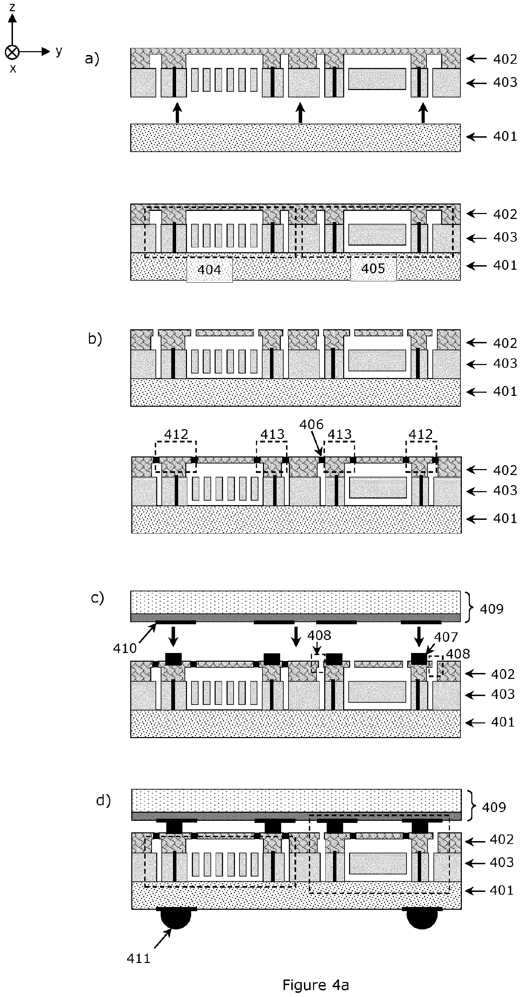

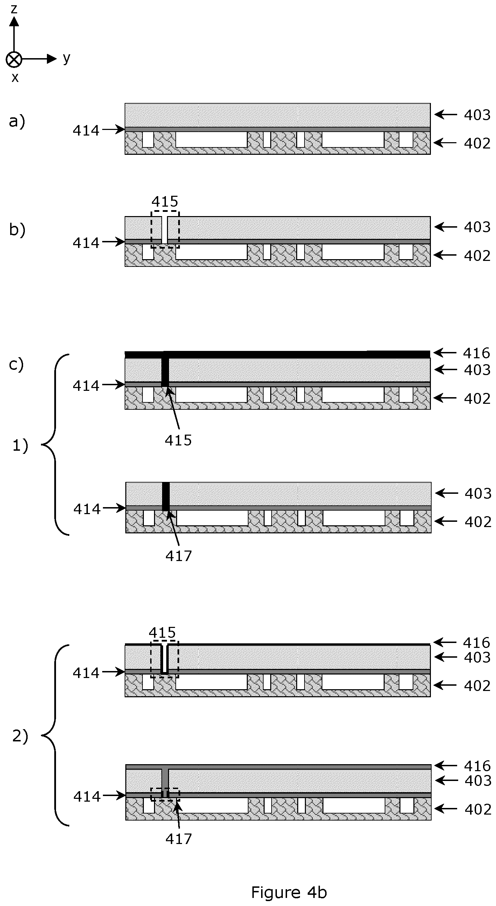

The MEMS system of this disclosure may be fabricated according to the following process steps, illustrated in Figure 4a:
Step a:
   - Providing a cap layer 401, fabricated according to a standard process.
   - Providing a prefabricated handle layer 402 and a device layer 403 on top of the handle layer 402.
      ∘ The handle layer 402 and the device layer 403 may be electrically connected by, for example, polysilicon plug. The polysilicon plug may be fabricated according to the following steps, as illustrated in Figure 4b:
         a) Attaching the device layer to the handle layer with an insulator layer 414 in-between;
         b) Etching a narrow opening(s) 415 through the device layer and the insulator layer until reaching the handle layer;
         c) Option 1: Depositing a polysilicon layer 416 so that the narrow opening 415 is entirely filled with polysilicon to form a polysilicon electrical contact 417 (plug). The layer of polysilicon on the surface of the device layer is removed;
            Option 2: Depositing a polysilicon layer 416 so that only the surface of the narrow opening 415 is coated with polysilicon. The polysilicon layer of the surface of the device layer is then oxidized using thermal oxidation process. When the oxidation time is correct, then the electrical contact(s) 417 between the device and the handle layer remains and rest of the narrow opening is filled by oxidized polysilicon.
      ∘ Optionally, the handle wafer may be recessed to define at least one isolated enclosure of the MEMS system.
         - Bonding the cap layer to the device layer by means of, for example, anodic bonding. This step results in forming at least one isolated enclosure between the handle layer and the cap layer. If more than one isolated enclosures are designed, a first isolated enclosure 404 and a second isolated enclosure 405 may be formed in this step. The bonding is performed at a pressure which is set in the isolated enclosure(s) in the step.
Step b:
   - Etching the handle layer 402, for example against the oxide layer with, for example, silicon plasma etching, to form openings in the handle layer.
   - Growing a second oxide layer 406 over the handle layer with, for example, PECVD, to fill the openings in the handle layer with the second oxide.
   - Removing (not illustrated) the second oxide from the surface of the handle layer with, for example, PECVD, so that only openings remain filled with the second oxide. The remaining areas filled with the second oxide layer 406 may define ASIC via regions 412 and MEMS via regions 413 in the handle layer.
Step c:
   - Adding bonding areas 407 to the surface of the handle layer in the ASIC via and MEMS via regions. The bonding areas 407 may for example, be metal areas deposited by means of sputtering and patterning. Material of the metal areas may be germanium-titanium.
   - Removing the second oxide from one of the openings 408 in the handle layer with, for example, oxide plasma etch, in order to access the second isolated enclosure, if present.
   - Providing an ASIC layer 409, fabricated according to the standard process, and adding bonding areas 410 such as, for example, metal areas for metal bonding. Material of the metal areas may be aluminium.
   - Bonding the ASIC layer 409 to the handle layer 402 by aligning bonding areas 407 and 410 in the ASIC via and MEMS via regions. The bonding may, for example, be a metal bonding performed at a vacuum, so that pressure in the second isolated enclosure (if present) is set to vacuum in this step. The metal bonding may be germanium-aluminum bonding.
Step d:
   - Option 1: external connections 411 may be added to the cap layer in order to provide an electrical connection to the outside components. External connections may be metal pads and tin balls.
   - Option 2 (not illustrated in Figure 4): the ASIC wafer may be wire bonded to the external components.

The disclosed fabrication method relates to the fabrication of MEMS systems wherein multiple systems are simultaneously manufactured from stacked wafers through wafer-level processing. After completing the fabrication steps, the wafers are diced to produce individual MEMS systems.

## Claims

1. A microelectromechanical system, comprising:
- an ASIC layer, wherein the ASIC layer comprises a control circuit,
- a handle layer, wherein the handle layer comprises a first side and a second side,
- a device layer, wherein the device layer comprises a first side and a second side, wherein the first side of the device layer is attached to the second side of the handle layer,
- and a cap layer attached to the second side of the device layer, **characterized in that**
- the device layer is electrically connected to the ASIC layer through the handle layer,
- the first side of the handle layer is attached to the ASIC layer.

2. The microelectromechanical system of claim 1, wherein the handle layer and device layer are electrically connected by means of polysilicon plugs.

3. The microelectromechanical system of any of the preceding claims, wherein the ASIC layer is bonded to the handle layer.

4. The microelectromechanical system of any of the preceding claims, wherein the ASIC layer is electrically connected to the cap layer by means of ASIC vias in the handle layer and the device layer, and signals from the ASIC layer are routed outside of the microelectromechanical system from the cap layer.

5. The microelectromechanical system of any of claims 1-3, wherein signals from the ASIC layer outside of the MEMS system are configured to be routed directly from the ASIC layer.

6. The microelectromechanical system of claim 5, wherein the signals from the ASIC layer to outside of the MEMS system are configured to be routed through a wire connected to the ASIC layer.

7. The microelectromechanical system of any of the preceding claims, wherein a first isolated enclosure is formed between the cap layer and the handle layer.

8. The microelectromechanical system of any of the preceding claims, wherein a second isolated enclosure is formed between the cap layer and the ASIC layer.

9. The microelectromechanical system of any of claim 8, wherein pressure in the first enclosure is different from pressure in the second enclosure.

10. The microelectromechanical system of any of claims 7-9, wherein the device layer comprises a first movable structure, and the first movable structure is suspended in the first isolated enclosure.

11. The microelectromechanical system of any of claims 8-10, wherein the device layer comprises a second movable structure, and wherein the second movable structure is suspended in the second isolated enclosure.

12. The microelectromechanical system of any of claims 8-11, wherein the cap layer comprises a first measurement electrode in the second isolated enclosure, and wherein the first measurement electrode is electrically connected to the ASIC layer by means of a measurement via, wherein the measurement via is arranged through the device layer and the handle layer.

13. A method of fabricating a microelectromechanical system of any of the preceding claims, comprising steps of:
- providing a handle layer with a device layer on its second side, wherein the handle layer is electrically connected to the device layer,
- attaching a cap layer to the device layer,
- attaching an ASIC layer to a first side of the handle layer, so that the device layer is electrically connected to the ASIC layer through the handle layer.
